# EUROPÄISCHE PATENTSCHRIFT

(11) **EP 1 670 876 B1**
(45) Veröffentlichungstag und Bekanntmachung des Hinweises auf die Patenterteilung: **29.04.2020**
(21) Anmeldenummer: 04786853.4
(22) Anmeldetag: 24.09.2004
(51) Int. Cl.: C09K 11/79, H01L 33/00

(54) **HOCHEFFIZIENTER LEUCHTSTOFF**
HIGHLY EFFICIENT LUMINOUS SUBSTANCE
LUMINOPHORE HAUTEMENT EFFICACE

(30) Priorität: 24.09.2003 DE 10344330
(43) Veröffentlichungstag der Anmeldung: 21.06.2006
(73) Patentinhaber: OSRAM GmbH, 80807 München (DE)
(72) Erfinder: FIEDLER, Tim, 81377 München (DE); JERMANN, Frank, 81739 München (DE)
(74) Vertreter: Epping - Hermann - Fischer
(86) Internationale Anmeldenummer: PCT/DE2004/002137
(87) Internationale Veröffentlichungsnummer: WO 2005/030905

(56) Entgegenhaltungen:
- EP-A- 1 104 799
- EP-A- 1 264 873
- EP-A- 1 413 618
- WO-A-2004/030109
- US-A- 4 897 319

## Beschreibung

### Technisches Gebiet

Die Erfindung geht aus von einem hocheffizienten Leuchtstoff aus der Klasse der Nitridosilikate gemäß dem Oberbegriff des Anspruchs 1. Es handelt sich dabei insbesondere um Leuchtstoffe aus der Klasse der Oxinitridosilikate des Sr.

### Stand der Technik

Leuchtstoffe des Typs Oxinitridosilikat sind an sich unter der Kurzformel MSiON bekannt; siehe beispielsweise "On new rare-earth doped M-Si-AI-O-N materials", J. van Krevel, TU Eindhoven 2000, ISBN 90-386-2711-4, Kap. 6. Sie sind dort mit Tb dotiert. Emission wird erreicht bei Anregung durch 365 nm oder 254 nm.

Die Druckschrift WO 2004/030109 A1 beschreibt ein Leuchtstoff der Formel MSi₂O₂N₂, wobei M aus der Gruppe der Erdalkalimetalle mit einem Anteil von Eu von 0,1 bis 30 % ausgewählt ist.

Das Grundgerüst des Wirtsgitters ist aus "Phase Relationships in the Sr-Si-O-N system", W.H. Zhu et al., J. Mat. Sei. Lett. 13 (1994), S. 560 - 562, bekannt, wo es in Zusammenhang mit keramischen Werkstoffen diskutiert wird. Dabei wurde festgestellt, dass diese Struktur in zwei Modifikationen, einer Niedertemperaturphase X1, und einer Hochtemperaturphase X2, vorkommt. Die Niedertemperaturphase, im folgenden NT abgekürzt, wird vornehmlich bei etwa 1300 °C erzeugt, während die Hochtemperaturphase, im folgenden HT abgekürzt, zunehmend mit höheren Temperaturen bis etwa 1600 °C erzeugt wird. Allerdings sind beide Phasen grundsätzlich schwer zu trennen, da sie dieselbe Grundstruktur, aber unterschiedliche Gitterkonstanten, besitzen. Die exakte Stöchiometrie beider Phasen kann von der Formel MSi₂O₂N₂ abweichen.

### Darstellung der Erfindung

Es ist Aufgabe der vorliegenden Erfindung, einen Leuchtstoff gemäß dem Oberbegriff des Anspruchs 1 bereitzustellen, dessen Effizienz möglichst hoch ist. Eine weitere Aufgabe ist es, eine Lichtquelle mit diesem Leuchtstoff sowie eine Verfahren zur Herstellung dieses effektiven Leuchtstoffs anzugeben.

Diese Aufgaben werden durch die kennzeichnenden Merkmale des Anspruchs 1, 11 bzw. 15 gelöst. Besonders vorteilhafte Ausgestaltungen finden sich in den abhängigen Ansprüchen.

Bisher gibt es keinen grün emittierenden Leuchtstoff hoher Effizienz, der gleichzeitig unempfindlich gegen äußere Einflüsse ist und außerdem durch Blau- bzw. UVemittierende LEDs gut anregbar ist.

Der Vergleichsleuchtstoff MSi₂O₂N₂:Eu (M = Ca, Sr, Ba) ist im Falle der Sr-dominierten Ausführungsform mit M = Sr(_{1-x-y})Ba_{y}Caₓ mit 0 ≤x+y< 0,5, im folgenden Sr-Sion genannt, nur schwer beherrschbar. Obwohl einzelne Versuchsbedingungen hervorragende Ergebnisse liefern, fehlt bislang eine Richtschnur, um zuverlässig gewünschte Ergebnisse zu erhalten. Hinzu kommt eine gewisse Neigung, dass sich bei hoher Temperaturbelastung die Effizienz des Leuchtstoffs verringert und der Farbort zu stark variiert. Bevorzugt sind insbesondere: y = 0 mit 0 ≤ x ≤ 0,3 und x= 0 mit 0 ≤ y ≤ 0,1.

Überraschenderweise hat sich nun gezeigt, dass sich die beiden Phasen in ihrer Eignung als Leuchtstoff grundlegend unterscheiden. Während die NT-Phase als Eudotierter Leuchtstoff nur bedingt zu gebrauchen ist, und eher orange-rot emittiert, zeigt die HT-Phase eine hervorragende Eignung als Leuchtstoff, der grün emittiert. Häufig liegt eine Mischung beider Modifikationen vor, die breitbandig beide Emissionen erkennen lässt. Gewünscht ist daher, die HT-Phase möglichst rein, mit mindestens 50 % Anteil, bevorzugt mindestens 70 %, besonders bevorzugt mindestens 85% Anteil herzustellen.

Dafür ist ein Glühprozess erforderlich, der bei mindestens 1300 °C, aber nicht mehr als 1600 °C durchgeführt wird. Bevorzugt ist ein Temperaturbereich von etwa 1450 bis 1580 °C, da bei geringerer Temperatur zunehmend NT-Phase entsteht und bei höherer Temperatur der Leuchtstoff zunehmend schlechter verarbeitbar ist, und ab etwa 1600 °C als hart gesinterte Keramik oder Schmelze vorliegt. Der optimale Temperaturbereich hängt von der genauen Zusammensetzung und den Eigenschaften der Ausgangsmaterialien ab.

Besonders wichtig für das Herstellen eines effizienten Leuchtstoffs des Typs Sr-Sion ist ein Ansatz der Ausgangsprodukte, der im Wesentlichen stöchiometrisch ist unter Verwendung der Grundkomponenten SiO ₂, SrCO ₃ sowie Si ₃ N ₄. Sr steht hier beispielhaft stellvertretend für M. Die Abweichung sollte insbesondere 10 %, bevorzugt 5 %, des idealen stöchiometrischen Ansatzes nicht überschreiten, wobei auch die etwaige Zugabe eines Schmelzmittels, wie es oft üblich ist, dabei eingeschlossen ist. Besonders bevorzugt ist eine maximale Abweichung von 1 %. Hinzu kommt ein Vorläufer für den Europium-Beitrag der Dotierung, der beispielsweise als Oxid Eu ₂ O ₃ realisiert wird. Diese Erkenntnis steht im Gegensatz zu der bisherigen Vorgehensweise, die Grundkomponente SiO ₂ deutlich unterstöchiometrisch zuzugeben. Besonders überraschend ist diese Erkenntnis auch deswegen, weil andere als Leuchtstoff empfohlene Sione wie Ba-Sion gerade im SiO ₂-Unterschuss hergestellt werden sollen.

Ein entsprechender Ansatz für das Sr-Sion MSi₂O₂N₂ verwendet daher 11 bis 13 Gew.-% SiO₂ , 27 bis 29 Gew.-% Si ₃ N ₄ , Rest SrCO ₃. Ba- und Ca- Anteile an M werden entsprechend als Carbonat zugesetzt. Europium wird entsprechend der gewünschten Dotierung, beispielsweise als Oxid oder Fluorid, als Ersatz für SrCO ₃ zugesetzt. Der Ansatz MSi₂O₂N₂ meint dabei auch etwaige Abweichungen von der exakten Stöchiometrie, soweit sie hinsichtlich der Ladungserhaltung ausgeglichen sind.

Als besonders günstig hat sich erwiesen, dass die Ausgangskomponenten des Wirtsgitters, insbesondere Si ₃ N ₄, möglichst hohe Reinheit besitzen. Besonders bevorzugt ist daher Si ₃ N ₄, das aus der flüssigen Phase, ausgehend beispielsweise von Siliziumtetrachlorid, synthetisiert ist. Als kritisch hat sich insbesondere die Verunreinigung mit Wolfram und Kobalt, erwiesen. Hier sollte die Verunreinigung möglichst gering sein, insbesondere sollte sie jeweils kleiner 100 ppm, insbesondere kleiner 50 ppm, sein, bezogen auf diese Vorläufersubstanzen. Des Weiteren ist eine möglichst hohe Reaktivität vorteilhaft, sie lässt sich durch die reaktive Oberfläche (BET) quantifizieren. Diese sollte mindestens 6 m²/g betragen, vorteilhaft mindestens 8 m²/g. Auch die Verunreinigung an Aluminium und Calcium, bezogen auf diese Vorläufersubstanz Si ₃ N ₄, sollte möglichst unter 100 ppm liegen.

Bei Abweichung von der oben angegebenen Verfahrensführung in Bezug auf stöchiometrischen Ansatz und Temperaturführung entstehen als unerwünschte Fremdphasen in zunehmendem Maße Nitridosilikate MxSiyNz wie etwa M2Si5N8, wenn die SiO₂-Zugabe zu niedrig angesetzt wird, so dass ein Stickstoffüberschuss entsteht. Obwohl diese Verbindung an sich ein bemerkenswerter Leuchtstoff ist, ist sie in Zusammenhang mit der Synthese des Sr-Sions genauso wie andere Nitridosilikate äußerst störend, weil diese Fremdphasen die grüne Strahlung des Sr-Sions absorbieren und evtl., in die bekannte rote Strahlung der Nitridosilikate umwandeln. Umgekehrt entstehen bei zu hoher SiO ₂-Zugabe Sr-Silikate wie beispielsweise Sr₂SiO₄ weil ein Sauerstoffüberschuss entsteht. Beide Fremdphasen absorbieren die nutzbare grüne Emission oder führen zumindest zu Gitterdefekten wie Leerstellen, die die Effizienz des Leuchtstoffs stark beeinträchtigen. Als Anhaltspunkt dient die Richtschnur, dass der Anteil der Fremdphasen möglichst unter 15 %, bevorzugt sogar unter 5 %, liegen soll. Dies korrespondiert im XRD-Spektrum des synthetisierten Leuchtstoffs mit der Forderung, dass beim XRD-Ablenkwinkel 2 θ im Bereich 25 bis 32° die Intensität aller Fremdphasenpeaks kleiner als 1/3, bevorzugt kleiner als ¼, besonders bevorzugt kleiner als 1/5, der Intensität des die HT-Modifikation kennzeichnenden Hauptpeaks bei etwa 31,8° sein soll. Dies gilt vor allem für die Fremdphasen vom Typ SrxSiyNz, insbesondere Sr2Si5N8.

Im Falle einer optimierten Verfahrensführung lässt sich zuverlässig eine Quanteneffizienz von 80 bis deutlich über 90 % erzielen. Dagegen wird bei unspezifischer Verfahrensführung die Effizienz typisch im Bereich von höchstens 50 bis 60 % Quanteneffizienz liegen.

Erfindungsgemäß lässt sich somit ein Leuchtstoff herstellen, der ein Oxinitridosilikat der Formel MSi₂O₂N₂ (M = Ca, Sr, Ba) darstellt, das mit zweiwertigem Eu aktiviert ist, unter evtl. weiterer Zugabe von Mn als Koaktivator, wobei der Leuchtstoff überwiegend oder allein, also zu mehr als 50 % des Leuchtstoffs, bevorzugt zu mehr als 85% des Leuchtstoffs, aus der HT-Phase besteht. Diese HT-Modifikation zeichnet sich dadurch aus, dass sie breitbandig anregbar ist, nämlich in einem weiten Bereich von 50 bis 480 nm, insbesondere 150 bis 480 nm, besonders bevorzugt von 250 bis 470 nm, dass er eine extrem hohe Stabilität gegen äußere Einflüsse besitzt, also bei 150°C an Luft keine messbare Degradation zeigt, und dass er eine extrem gute Farbortstabilität unter wechselnden Bedingungen zeigt. Weitere Pluspunkte sind seine geringe Absorption im Roten, was besonders bei Leuchtstoffmischungen vorteilhaft ist. Dieser Leuchtstoff wird im Folgenden oft Sr-Sion:Eu genannt. Ein Überwiegen der HT-Modifikation ist u.a. daran erkennbar, dass der kennzeichnende Peak der NT-Modifikation im XRD-Spektrum bei etwa 28,2 ° eine Intensität von weniger als 1:1, bevorzugt weniger als 1:2, im Vergleich zum Peak mit höchster Intensität aus der Dreiergruppe der Reflexe der HT-Modifikation, die im XRD-Spektrum bei 25 bis 27° liegen, aufweist. Die hier aufgeführten XRD-Spektren beziehen sich jeweils auf eine Anregung durch die bekannte Cu-K_{α} Linie.

Bei gleicher Aktivatorkonzentration zeigt dieser Leuchtstoff ein anderes Emissionsverhalten als die NT-Variante gleicher Stöchiometrie. Die Halbwertsbreite der HT-Variante ist im Falle der optimierten HT-Variante wesentlich geringer als bei der einfachen fremdphasen- und defekthaltigen Mischung und liegt im Bereich 70 bis 80 nm, während die einfache Fremdphasen- bzw. defekthaltige Mischung eine Halbwertsbreite von etwa 110 bis 120 nm zeigt. Die dominante Wellenlänge ist bei der HT-Modifikation generell kürzer, typisch 10 bis 20 nm kürzer, als bei einer deutlich fremdphasenhaltigen Probe. Hinzu kommt, dass die Effizienz der hochreinen HT Modifikation typisch um mindestens 20 % höher, teilweise deutlich noch höher, als bei der NT-dominierten oder hoch fremdphasenhaltigen Mischung liegt.

Ein kennzeichnendes Merkmal eines ausreichend geringen Anteils der NT-Modifikation und Fremdphasen ist eine Halbwertsbreite (FWHM) der Emission von weniger als 90 nm. Denn je geringer der Anteil an Fremdphasen, desto geringer ist der Anteil der spezifischen orange-roten Emission der fremdphasenreichen Modifikation, insbesondere der Nitridosilikat-Fremdphasen Sr-Si-N-Eu wie vor allem Sr2Si5N8:Eu.

Hilfreich zur Charakterisierung sind neben der verringerten Halbwertsbreite die oben angegebenen typischen Reflexe im XRD-Spektrum, die die andere Kristallstruktur verdeutlichen.

Der vorherrschende Peak im XRD-Spektrum der HT-Modifikation ist der Peak bei etwa 31,7°. Weitere prominente Peaks sind die drei Peaks etwa gleicher Intensität zwischen 25 und 27° (25,3 und 26,0 und 26,3°), wobei der Peak mit kleinster Ablenkung der intensivste ist. ein weiterer intensiver Peak ist 12,6°.

Dieser Leuchtstoff ist vor allem grün emittierend mit einer Dominanzwellenlänge im Bereich 555 bis 565 nm.

Auch eine geringfügige Beimengung der Gruppe AIO als Ersatz der Gruppe SiN im Molekül des Oxinitridosilikats der Formel MSi₂O₂N₂ ist möglich, insbesondere bis maximal 30 % des SiN-Anteils.

Beide Phasen des Sr-Sion:Eu können analog zu den zwei strukturell unterschiedlichen Wirtsgittermodifikationen kristallisieren und jeweils über die Ansatzstöchiometrie SrSi2O2N2:Eu hergestellt werden. Geringe Abweichungen von dieser Stöchiometrie sind möglich. Die mit Eu dotierten Wirtsgitter lumineszieren überraschenderweise beide bei Anregung im Blauen oder UV, allerdings je nach Wirtsgittermodifikation mit anderer Emissionsfarbe. Die NT-Modifikation zeigt eine orangefarbene Emission, die HT-Modifikation eine grüne Emission bei etwa λ_{dom} = 560 nm mit prinzipiell deutlich höherer Effizienz. Je nach Dotiergehalt und Dotiermaterial (Eu oder Eu, Mn) sowie den relativen Anteilen der HT- und NT-Modifikation lässt sich eine gewünschte Eigenschaft des Leuchtstoffs genau einstellen.

Ein Vorzug der HT-Phase ist die über einen sehr weiten Spektralbereich gleichmäßig gute Anregbarkeit bei nur wenig variierender Quanteneffizienz.

Außerdem hängt die Lumineszenz der HT-Modifikation in einem weiten Temperaturbereich nur schwach von der Temperatur ab. Damit ist erstmals ein grün emittierender Leuchtstoff, bevorzugt für LED-Anwendungen, gefunden, der ohne besondere Maßnahmen zur Stabilisierung auskommt. Dies zeichnet ihn besonders gegen die bisher als aussichtsreichste Kandidaten angesehenen Leuchtstoffe für diese Aufgabe aus, nämlich Thiogallat-Leuchtstoffe oder Chlorosilikate.

Generell kann dieser Leuchtstoff von einer ganzen Reihe von Lichtquellen effizient angeregt werden: insbesondere von LED-Chips (beispielsweise vom Typ InGaN), die UV oder blau im Bereich 300 bis 480 nm als Primärstrahlung emittieren; des weiteren von allen Arten von Lampen, insbesondere Hg-Niederdruck- und Hochdrucklampen, sowie UV- und VUV-Strahler zwischen etwa 50, bevorzugt mindestens 150 nm, und 400 nm, beispielsweise Excimerstrahler. Bei 160 nm ist die Quanteneffizienz immer noch etwa 50% der maximalen Quanteneffizienz.

Dieser Leuchtstoff eignet sich besonders gut für die Anwendungen bei vollfarbtauglichen Lumineszenzkonversions-LEDs sowie Lumineszenzkonversions-LEDs mit beliebig einstellbaren Farben auf Basis eine UV-Blau primär emittierenden LED.

Die Sionverbindungen mit M = (Sr.Ba), bevorzugt ohne Ba oder mit Ba-Anteil bis zu 10 %, stellen effiziente Leuchtstoffe mit einem weiten Bereich der Emissionsmaxima dar. Diese liegen meist kurzwelliger als bei reinem Sr-Sion, bevorzugt zwischen 520 und 565 nm. Der erreichbare Farbraum lässt sich außerdem durch geringe Beigaben (bevorzugt bis 30 mol-%) an Ca und/oder Zink erweitern; dadurch werden die Emissionsmaxima eher in den langwelligeren Bereich, verglichen mit reinem Sr-Sion, verschoben, sowie durch partiellen Ersatz (bis 25 mol-%) von Si durch Ge und/oder Sn.

Eine weitere Ausführungsform ist die Teilsubstitution von M, insbesondere Sr, durch drei- oder einwertige Ionen wie La3+ oder Li+. Bevorzugt ist ein Anteil dieser Ionen von maximal 20 mol-% des M.

Bevorzugt lässt sich der erfindungsgemäße Leuchtstoff für Lumineszenzkonversions-LED zur Erzeugung von weißem Licht einsetzen, sei es mit blauer Primärstrahlung wobei Sr-Sion als Grünkomponente zusammen mit SrS:Eu²⁺, als Rotkomponente eingesetzt werden kann, aber auch mit UV-Primärstrahlung, wobei mittels bekannter blau und rot emittierender Leuchtstoffe sowie einem erfindungsgemäß grün emittierenden Leuchtstoff weißes Licht erzeugt wird. Kandidaten für die blaue Komponente sind hier an sich bekannt, beispielsweise eignen sich BaM-gAl₁₀O₁₇:Eu²⁺ (bekannt als BAM) oder Ba₅SiO₄(Cl,Br)₆:Eu²⁺ oder CaLa₂S₄:Ce³⁺ oder auch (Sr,Ba,Ca)₅(PO₄)₃Cl:Eu²⁺ (bekannt als SCAP). Als grüne Komponente eignet sich der erfindungsgemäße Leuchtstoff. Zur roten Emission lässt sich ein Rotleuchtstoff einsetzen. Gut geeignet sind ((Y,La,Gd,Lu)₂O₂S:Eu³⁺, oder auch (Ca,Sr)2Si₅N₈ :EU²⁺.

### Figuren

Im Folgenden soll die Erfindung anhand zweier Ausführungsbeispiele näher erläutert werden. Es zeigen:
- Figur 1: ein Emissionsspektrum eines ersten Oxinitridosilikats;
- Figur 2: das Reflektionsspektrum dieses Oxinitridosilikats;
- Figur 3: ein Spektrum der Anregbarkeit von Sr-Sion als Funktion der Anregungswellenlänge;
- Figur 4: das Temperaturverhalten von Sr-Sion;
- Figur 5: XRD-Spektren verschiedener Leuchtstoffe vom Typ Sr-Sion;
- Figur 6 u.11: ein Halbleiterbauelement, das als Lichtquelle für weißes Licht dient;
- Figur 7: ein Emissionsspektrum zweier Leuchtstoffe mit und ohne Fremdphasen.
- Figur 8-10: ein Emissionsspektrum weiterer Oxinitridosilikate

### Beschreibung der Zeichnungen

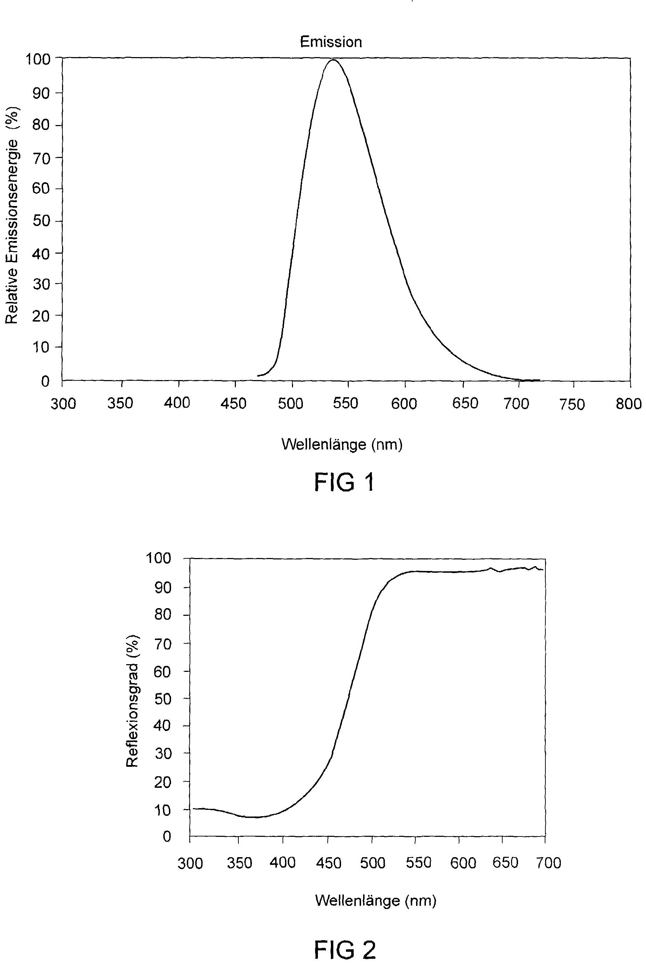

Ein konkretes Beispiel für den erfindungsgemäßen Leuchtstoff ist in Figur 1 gezeigt. Es handelt sich um die Emission des Leuchtstoffs SrSi₂N₂O₂:(5 % Eu²⁺) in HT-Modifikation, bei dem der Eu-Anteil 5 mol-% der von Sr besetzten Gitterplätze ausmacht. Das Emissionsmaximum liegt bei 540 nm, die mittlere Wellenlänge (dominante Wellenlänge) bei 560 nm. Der Farbort ist x=0,357; y=0,605. Die Anregung erfolgte bei 460 nm, die FWHM ist 76 nm.

Die Herstellung erfolgt in der Weise, dass zunächst die Ausgangsstoffe SrCO₃, Si₃N₄ und SiO₂ in exakter Stöchiometrie miteinander gemischt werden und die Mischung anschließend im Ofen bei 1500 °C unter N₂ und H₂ reduzierend über 8 Std. geglüht wird. Dabei wird ein stöchiometrischer Ansatz genommen, mit 12,05 Gew.-% SiO ₂, 28,10 Gew.-% Si ₃ N ₄ sowie 56,27 Gew.-% SrCO ₃ zuzüglich 3,53 Gew.-% Eu ₂O ₃ .Damit ersetzen 5 mol-% Eu als Aktivator das Kation Sr.

Figur 2 zeigt das diffuse Reflexionsspektrum dieses Leuchtstoffs. Es zeigt ein ausgeprägtes Minimum im Bereich unter 440 nm und eine ausreichende Absorption bis 470 nm, das somit die gute Anregbarkeit in diesem Bereich demonstriert.

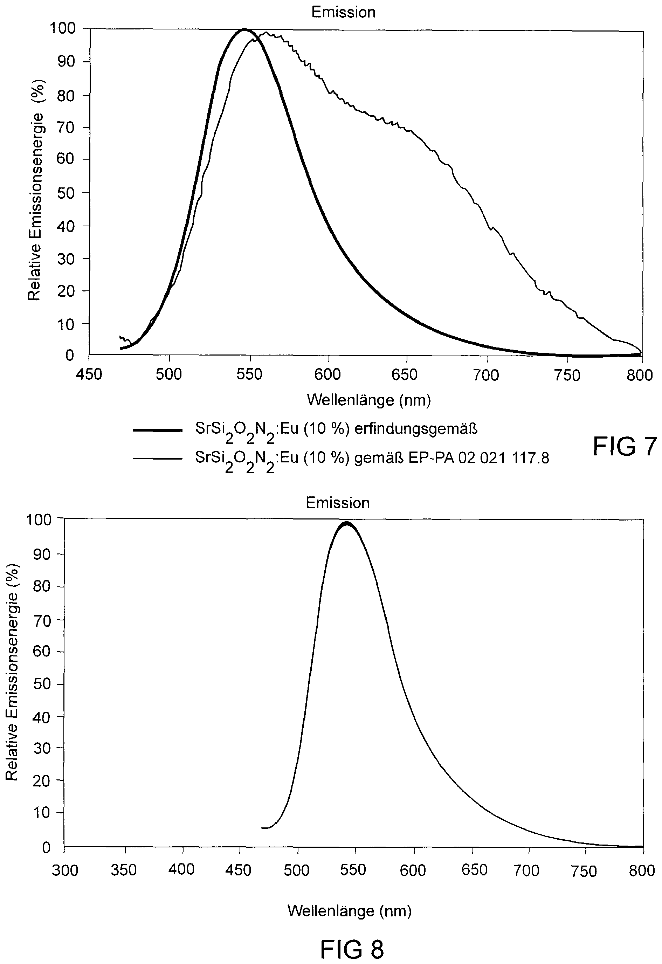

Figur 8 zeigt ein Beispiel für einen hocheffizienten grün emittierenden Leuchtstoff. Es handelt sich um die Emission des Leuchtstoffs SrSi₂N₂O₂:(10 % Eu²⁺) in HT-Modifikation, bei dem der Eu-Anteil 10 mol-% der von Sr besetzten Gitterplätze ausmacht. Das Emissionsmaximum liegt bei 545 nm, die mittlere dominante Wellenlänge bei 564 nm (λdom). Der Farbort ist x=0,393; y=0,577 Die Anregung erfolgte bei 460 nm. Die FWHM ist 84 nm.

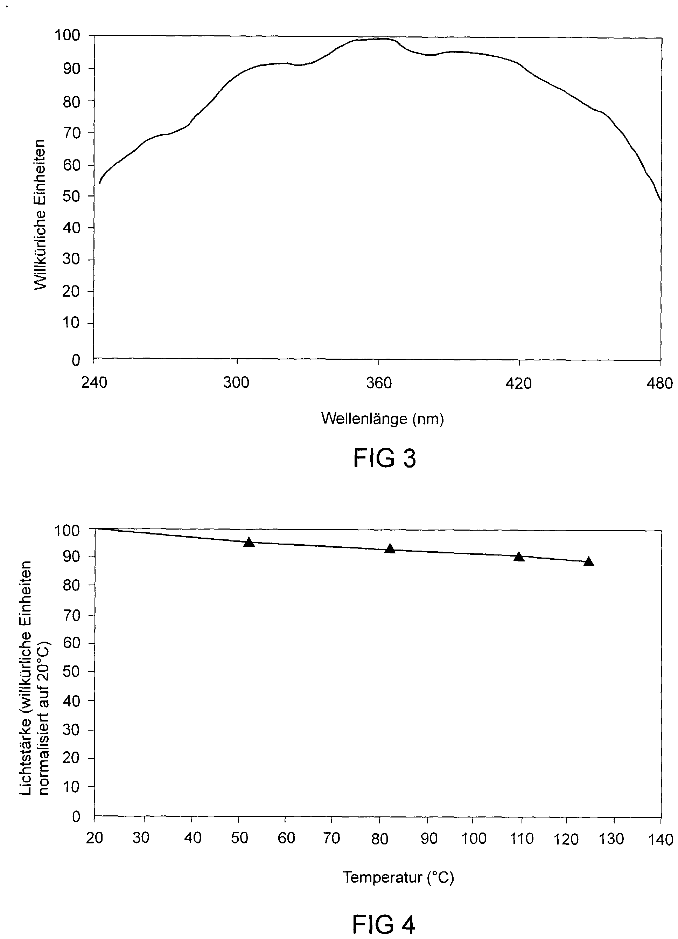

Fig. 3 zeigt ein Spektrum der Anregbarkeit von Sr-Sion mit 10 % Eu als Funktion der Wellenlänge. Die Anregbarkeit ist proportional dem Produkt aus Absorbierter Energie und Quanteneffizienz. Es zeigt sich, dass das erfindungsgemäße Sr-Sion über einen sehr weiten Wellenlängenbereich von 250 bis 470 m eine Anregbarkeit von über 50 % hat.

Fig. 4 zeigt das Temperaturverhalten dieses Leuchtstoffs. Die Temperaturlöschung ist erstaunlich gering und beträgt maximal 12 % bei sehr hoher Temperaturbelastung von 125 °C verglichen mit Raumtemperatur.

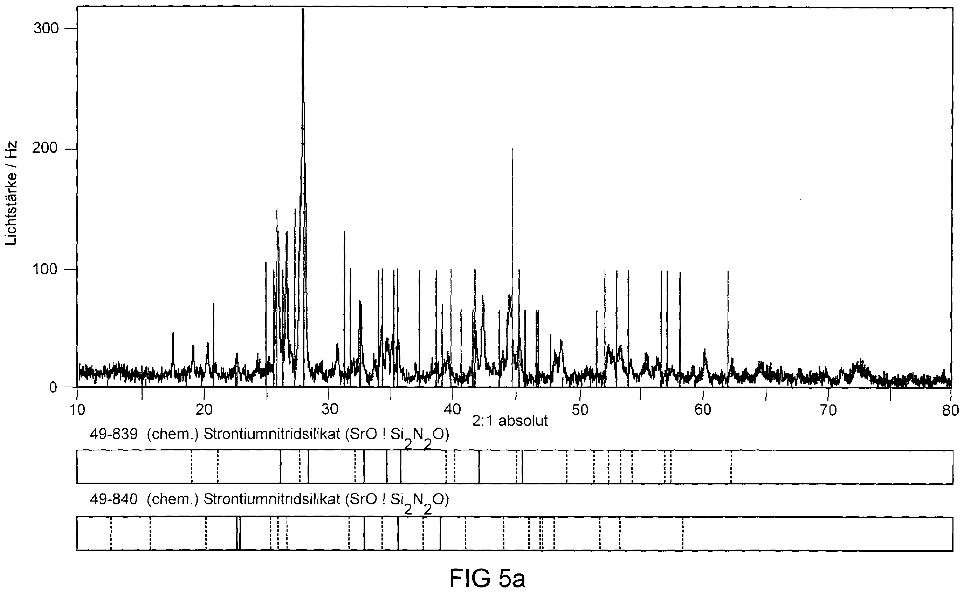

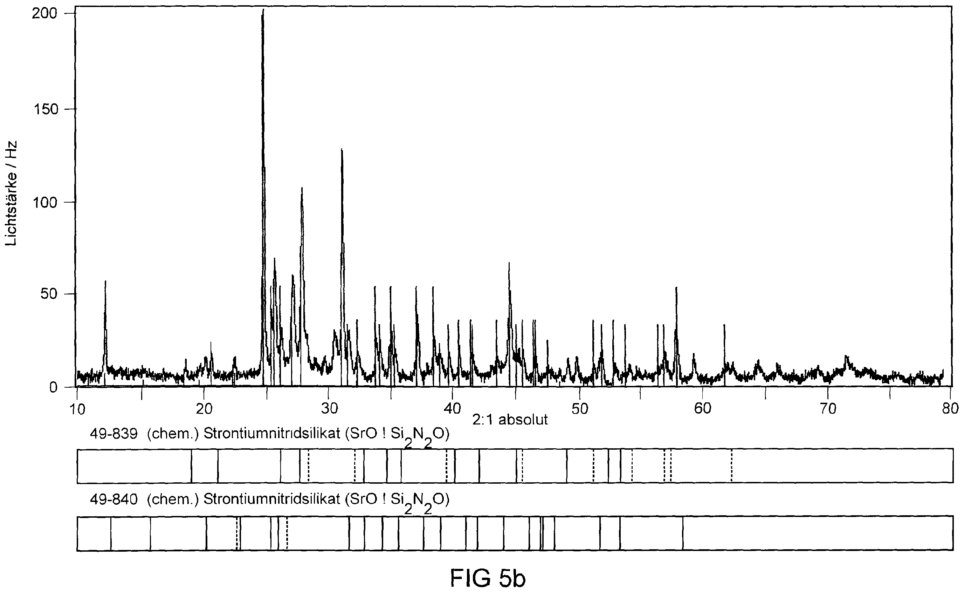

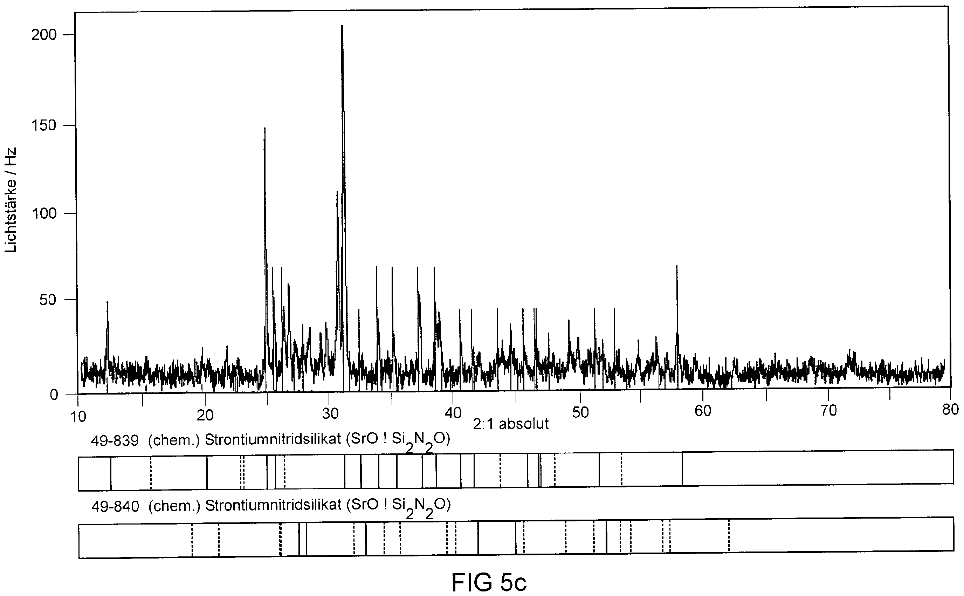

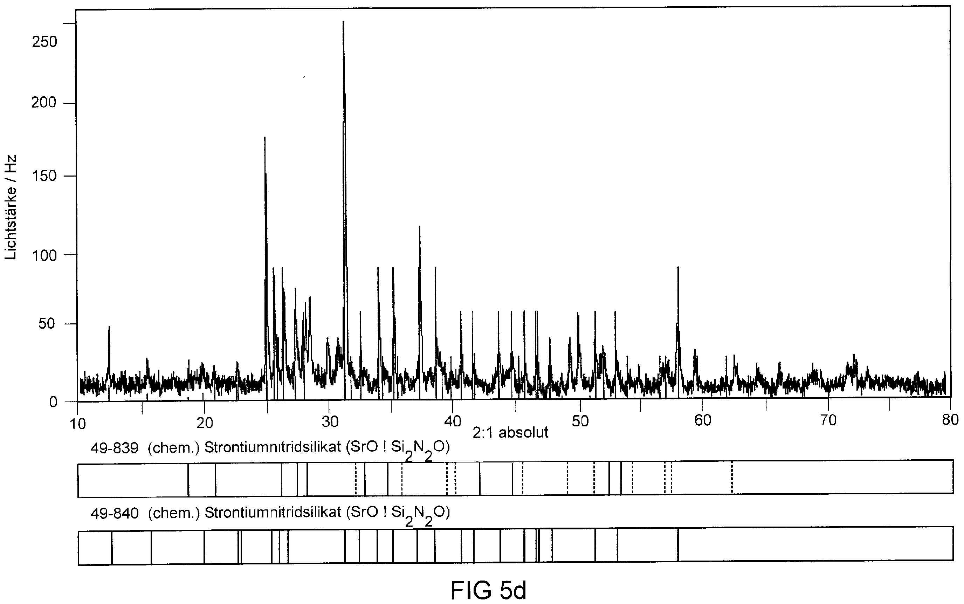

Die unterschiedliche Struktur verschieden hergestellter Leuchtstoffe ist in Figur 5 erläutert. Dort sind XRD-Spektren, also Röntgendiffraktogramme, von vier Leuchtstoffen des Typs Sr-Sion vorgestellt. Figur 5a zeigt als Vergleich ein XRD-Spektrum einer stark überwiegenden NT-Modifikation. Charakteristisch ist der starke Peak bei etwa 28,2°. Diese Probe erzielt eine Quanteneffizienz von etwa 10 % der HT-Modifikation, die Herstellung erfolgte mit wenig reaktivem Ausgangsmaterial bei etwa 1300°C Glühung. Figur 5b zeigt ein Vergleichsbeispiel eines XRD-Spektrums für eine Mischung mit mehr als 50 % HT-Anteil gegenüber dem NT -Anteil. Hier treten die XRD-Reflexe der HT-Modifikation bei etwa 31,7° und der Tripel-Reflex im Bereich bei 25 bis 27° zunehmend in den Vordergrund gegenüber dem prominenten NT-Reflex bei 28,2°. Die Quanteneffizienz im Vergleich zur HT-Modifikation beträgt etwa 70 %. Die Herstellung erfolgte bei etwa 1400 °C. In Figur 5c ist eine Vergleichsprobe gezeigt, bei der die Fremdphasen nicht sorgfältig ausgeschlossen wurden. Deutlich erkennbar ist vor allem der dem Nitridosilikat zuzuordnende Peak bei etwa 31,2°, der etwa 50 % der maximalen Peakhöhe des Charakteristischen Peaks der HT-Phase bei 31,7° ausmacht. Obwohl hier die NT-Modifikation stark unterdrückt ist, erreicht diese Probe nicht mehr als 40 % der Quanteneffizienz von reiner HT-Modifikation. Schließlich zeigt Figur 5d ein XRD-Spektrum für annähernd reines HT, deren Quanteneffizienz als Norm (100 %) für die anderen Proben diente. Fremdphasen und NT-Modifikation sind hier stark unterdrückt, was einer exakten stöchiometrischen Herstellung mit Glühung bei etwa 1500 °C und hoher Reinheit und Reaktivität der Ausgangsmaterialien geschuldet ist.

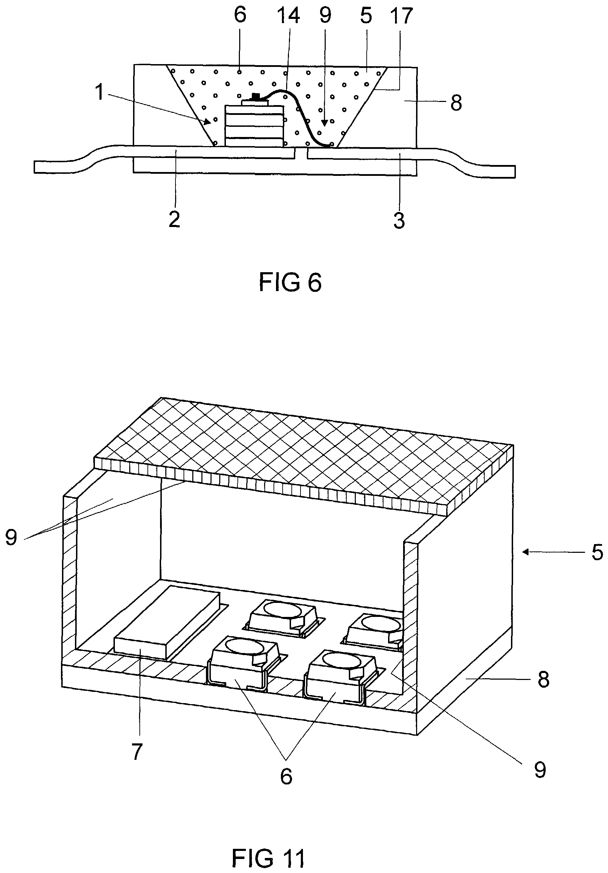

Der Aufbau einer Lichtquelle für weißes Licht auf RGB-Basis ist in Figur 6 explizit gezeigt. Die Lichtquelle ist ein Halbleiterbauelement mit einem Chip 1 des Typs InGaN mit einer Peakemissionswellenlänge im UV von beispielsweise 405 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Epoxidgießharz (80 bis 90 Gew.-%) und Leuchtstoffpigmente 6 (weniger als 20 Gew.-%) enthält. Ein erster Leuchtstoff ist das als erstes Ausführungsbeispiel vorgestellte grün emittierende Oxinitridosilikat, der zweite ist ein blau emittierender Leuchtstoff, hier insbesondere BAM, der dritte ist ein rot emittierendes Nitridosilikat vom Typ (Ca,Sr)2Si5N8:Eu, hier unter Einschluss der reinen Sr und Ca-Variante sowie Mischungen aus Sr und Ca. Die Ausnehmung hat eine Wand 17, die als Reflektor für die Primär- und Sekundärstrahlung vom Chip 1 bzw. den Pigmenten 6 dient.

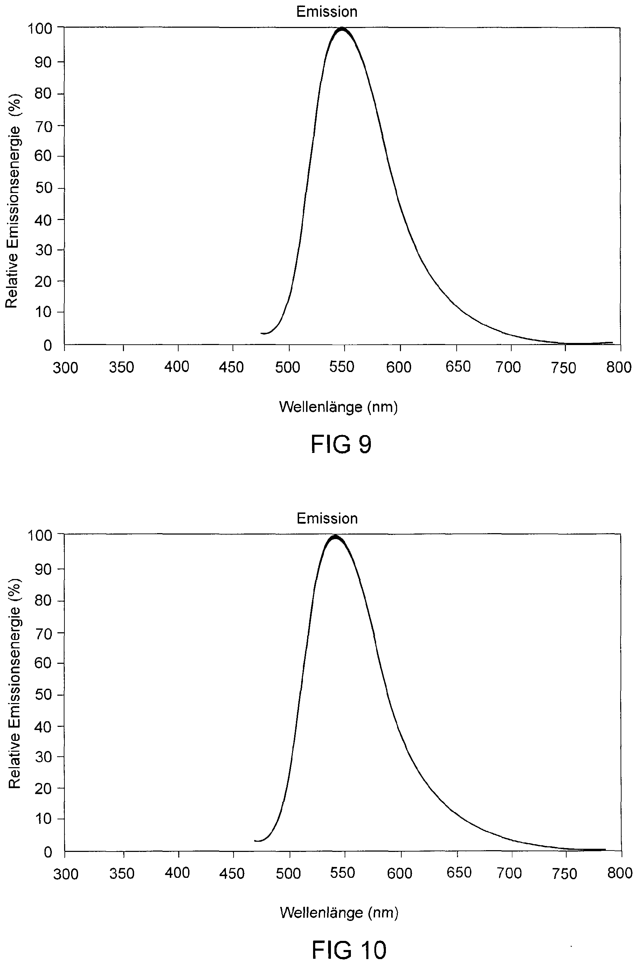

Fig. 9 zeigt ein Beispiel der Emission für ein Misch-Sion MSi₂O₂N₂ :Eu10% bei dem M = ( 10 % Ca und Rest Sr). Anregung 460 nm; Farbort x/y 0,397/0,576 ; dom. Wellenlänge 564 nm FWHM = 84 nm; Quanteneffizienz ca. 70 %.

Fig. 10 zeigt ein Beispiel der Emission für ein Misch-Sion MSi₂O₂N₂ :Eu10% bei dem M = ( 10 % Ba und Rest Sr). Anregung 460 nm; Farbort x/y 0,411/0,566 ; dom. Wellenlänge 566 nm FWHM = 86 nm; Quanteneffizienz ca. 67 %.

In einem weiteren Ausführungsbeispiel Fig. 11 wird wieder als das Leuchtstoffpigment eine Mischung aus derartigen drei Leuchtstoffen für RGB-Mischung verwendet. Jedoch sind diese auf den Wänden 9 eines äußeren Gehäuses angebracht, das mehrere LEDs vom Typ Lumineszenzkonversions-LED enthält.

Erstaunlicherweise hat sich gezeigt, dass ein besonders effizienter Leuchtstoff herstellbar ist, wenn streng darauf geachtet wird, dass die Ausgangsmaterialien, vor allem Si3N4, wenig Verunreinigungen enthalten. Besonders kritisch sind hier Verunreinigungen an W, Co, Al und Ca.

Der Ersatz der Gruppe SiN in MSi₂O₂N₂ durch AlO-Gruppen ist deswegen möglich, weil Al3+ und Si4+ vergleichbare lonengrößen haben und beide Gruppen vergleichbare Bindungslängen aufweisen.

## Patentansprüche

1. Hocheffizienter Leuchtstoff aus der Klasse der Oxinitridosilikate mit einem Kation M und der grundsätzlichen Formel M_{(1-c)}Si₂O₂N₂:D_{c}, wobei M Sr als Bestandteil enthält, und wobei D eine zweiwertige Dotierung mit Europium ist, **dadurch gekennzeichnet, dass** für M Sr allein oder M = Sr(_{1-x-y})Ba_{y}Caₓ mit x+y < 0,5 verwendet wird, wobei das Oxinitridosilikat vollständig oder überwiegend aus der hochtemperaturstabilen Modifikation HT besteht, und wobei der Anteil c des Eu am Kation M zwischen 0,1 und 20 mol-% von M ausmacht, und wobei der Anteil von Verunreinigungen an W und Co jeweils unter 100 ppm liegt, bezogen auf die Vorläufersubstanzen,
wobei in dem XRD-Spektrum des Leuchtstoffs der Anteil von Fremdphasen so gewählt ist, dass beim XRD-Ablenkwinkel 2θ im Bereich 25 bis 32° die Intensität aller Fremdphasenpeaks kleiner als 1/3 der Intensität des die HT-Modifikation kennzeichnenden Hauptpeaks bei etwa 31,8° ist.

2. Leuchtstoff nach Anspruch 1, **dadurch gekennzeichnet, dass** Sr als M den überwiegenden Anteil stellt und ein Teil von M, insbesondere bis zu 30 mol-%, durch Ba u/o Ca ersetzt ist.

3. Leuchtstoff nach Anspruch 1, **dadurch gekennzeichnet, dass** Sr als M den überwiegenden Anteil stellt und ein Teil von M, insbesondere bis zu 30 mol-%, durch Li u/o La u/o Zn ersetzt ist.

4. Leuchtstoff nach Anspruch 1 , **dadurch gekennzeichnet, dass** ein Teil der Gruppe SiN im Oxinitridosilikat der Formel MSi₂O₂N₂, insbesondere bis zu 30 mol-%, durch die Gruppe AlO ersetzt ist.

5. Leuchtstoff nach Anspruch 1, **dadurch gekennzeichnet, dass** ein Teil von Eu, insbesondere bis zu 30 mol-%, durch Mn ersetzt ist.

6. Leuchtstoff nach Anspruch 1, **dadurch gekennzeichnet, dass** der Anteil von Verunreinigungen an W und Co unter 50 ppm liegt, bezogen auf die Vorläufersubstanzen.

7. Leuchtstoff nach Anspruch 1 , **dadurch gekennzeichnet, dass** das Oxinitridosilikat zu mehr als 70 %, insbesondere zu mehr als 85 %, aus der HT-Modifikation besteht.

8. Leuchtstoff nach Anspruch 1, **dadurch gekennzeichnet, dass** das Oxinitridosilikat überwiegend aus der HT-Modifikation besteht und dass der Anteil der Fremdphasen weniger als 15 % beträgt.

9. Leuchtstoff nach Anspruch 1, **dadurch gekennzeichnet, dass** die Halbwertsbreite (FWHM) der Emission des Leuchtstoffs bei photonischer Anregung, die aus einem Bereich mit Peakemission zwischen 50 und 480 nm stammt, weniger als 90 nm beträgt.

10. Leuchtstoff nach Anspruch 1, **dadurch gekennzeichnet, dass** in dessen XRD-Spektrum der Anteil der NT-Phase so gewählt ist, dass der kennzeichnende Peak der NT-Modifikation im XRD-Spektrum bei etwa 28,2° eine Intensität von weniger als 1:1, bevorzugt weniger als 1:2, im Vergleich zum Peak mit höchster Intensität aus der Dreiergruppe der Reflexe der HT-Modifikation, die im XRD-Spektrum bei 25 bis 27° liegen, aufweist.

11. Lichtquelle mit einer primären Strahlungsquelle, die Strahlung im kurzwelligen Bereich des optischen Spektralbereichs im Wellenlängenbereich 50 bis 480 nm emittiert, wobei diese Strahlung mittels mindestens einem ersten Leuchtstoff nach einem der vorhergehenden Ansprüche ganz oder teilweise in sekundäre längerwellige Strahlung, insbesondere im sichtbaren Spektralbereich, konvertiert wird.

12. Lichtquelle nach Anspruch 11, **dadurch gekennzeichnet, dass** als primäre Strahlungsquelle eine Leuchtdiode auf Basis von InGaN verwendet wird.

13. Lichtquelle nach Anspruch 12, **dadurch gekennzeichnet, dass** außerdem ein Teil der primären Strahlung mittels eines weiteren, zweiten Leuchtstoffs in längerwellige Strahlung konvertiert wird, wobei insbesondere die beiden Leuchtstoffe, nämlich der erste und der zweite, geeignet gewählt und gemischt sind um weißes Licht zu erzeugen.

14. Lichtquelle nach Anspruch 11, **dadurch gekennzeichnet, dass** ein Teil der primären Strahlung außerdem mittels eines dritten Leuchtstoffs in längerwellige Strahlung konvertiert wird, wobei dieser dritte Leuchtstoff im roten Spektralbereich, insbesondere mit Peak im Bereich 580 bis 670 nm, emittiert.

15. Verfahren zur Herstellung eines hocheffizienten Leuchtstoffs gemäß Anspruch 1, **gekennzeichnet durch** folgende Verfahrensschritte:
a) Bereitstellen der Ausgangsprodukte SiO₂, Si₃ N₄, Rest MCO₃, sowie eines Eu-Vorläufers in im Wesentlichen stöchiometrischen Verhältnis und Mischen der Produkte, wobei die Ausgangsprodukte eine hohe Reinheit in Bezug auf die Verunreinigung an W und Co von weniger als 100 ppm aufweisen.
b) Glühen der Mischung bei etwa 1300 bis 1600 °C, bevorzugt 1450 bis 1580 °C.

16. Verfahren nach Anspruch 15, **dadurch gekennzeichnet, dass** die Ausgangsprodukte eine hohe Reaktivität von mindestens 6 m²/g BET-Oberflache aufweisen.

17. Verfahren nach Anspruch 15, **dadurch gekennzeichnet, dass** der stöchiometrische Ansatz aller Komponenten auf mindestens 10 % genau eingehalten wird.

## Claims

1. High-efficiency phosphor from the class of the oxynitridosilicates having a cation M and the empirical formula M(_{1-c}) Si₂O₂N₂:D_{c}, where M contains strontium as a component, and where D is a divalent doping with europium, **characterized in that** strontium alone or M = Sr(_{1-x-y})Ba_{y}Caₓ with x+y < 0.5 is used for M, where the oxynitridosilicate consisting entirely or predominantly of the high-temperature stable modification HT, and wherein the proportion c of the Eu in the cation M being between 0.1 and 20 mol-% of M, and wherein the proportion of impurities of W and Co is in each case below 100 ppm, based on the precursor substances, wherein in the XRD spectrum of the phosphor the proportion of foreign phases is selected such that at the XRD deflection angle 2θ in the range 25 to 32° the intensity of all foreign phase peaks is less than 1/3 of the intensity of the main peak characterizing the HT modification at about 31.8°.

2. Phosphor according to claim 1, **characterized in that** Sr as M represents the predominant part and a part of M, in particular up to 30 mol-%, is replaced by Ba and / or Ca.

3. Phosphor according to claim 1, **characterized in that** Sr as M represents the predominant part and a part of M, in particular up to 30 mol-%, is replaced by Li and / or La and/or Zn.

4. Phosphor according to claim 1, **characterized in that** a part of the group SiN in the oxynitridosilicate of the formula MSi₂O₂N₂, in particular up to 30 mol-%, is replaced by the group AlO.

5. Phosphor according to claim 1, **characterized in that** a part of europium, in particular up to 30 mol-%, is replaced by Mn.

6. Phosphor according to claim 1, **characterized in that** the proportion of impurities of W and Co is below 50 ppm, based on the precursor substances.

7. Phosphor according to claim 1, **characterized in that** the oxynitridosilicate consists of more than 70%, in particular more than 85%, of the HT modification.

8. Phosphor according to claim 1, **characterized in that** the oxynitridosilicate consists predominantly of the HT modification and that the proportion of foreign phases is less than 15%.

9. Phosphor according to claim 1, **characterized in that** the half-value width (FWHM) of the emission of the phosphor in the case of photonic excitation derived from a region with peak emission between 50 and 480 nm, is less than 90 nm.

10. Phosphor according to claim 1, **characterized in that** the proportion of the NT phase in its XRD spectrum is selected such that the characteristic peak of the NT modification in the XRD spectrum at about 28.2° has an intensity of less than 1:1, preferably less than 1:2, compared to the peak with the highest intensity from the triple group of the reflections of the HT modification, which are 25 to 27° in the XRD spectrum.

11. Light source with a primary radiation source, which emits radiation in the short-wave range of the optical spectral range in the wavelength range 50 to 480 nm, whereby this radiation is completely or partially converted into secondary longer-wave radiation, in particular in the visible spectral range, by means of at least one first phosphor according to one of the preceding claims.

12. Light source according to claim 11, **characterized in that** a light-emitting diode based on InGaN is used as the primary radiation source.

13. Light source according to claim 12, **characterized in that** additionally a part of the primary radiation is converted into longer-wave radiation by means of a further, second phosphor, wherein in particular the two phosphors, namely the first and the second, are suitably selected and mixed to produce white light.

14. Light source according to claim 11, **characterized in that** a part of the primary radiation is further converted into longer-wave radiation by means of a third phosphor, wherein the third phosphor emitting in the red spectral range, in particular with a peak in the range 580 to 670 nm.

15. Method of manufacturing a high-efficiency phosphor according to claim 1, **characterized by** the following method steps:
a) Providing the starting products SiO₂, Si₃N₄, rest MCO₃, as well as an Eu-precursor in an essentially stoichiometric ratio and mixing the products, wherein the starting products having a high purity with respect to the impurities of W and Co of less than 100 ppm.
b) Annealing the mixture at about 1300 to 1600 °C, preferably 1450 to 1580 ° C.

16. Method according to claim 15, **characterized in that** the starting products have a high reactivity of at least 6 m²/g BET surface.

17. Method according to claim 15, **characterized in that** the stoichiometric scale of all components is maintained to an accuracy of at least 10%.

## Revendications

1. Substance luminescente à haut rendement de la classe des oxynitridosilicates avec un cation M et la formule de base M(_{1-c}) Si₂O₂N₂: D_{c}, M contenant du strontium tant que composant, et D étant un dopage divalent à l'europium, **caractérisé en ce que** du strontium seul ou M = Sr(_{1-x-y})Ba_{y}Caₓ avec x+y < 0,5 est utilisé pour M, l'oxynitridosilicate étant entièrement ou principalement constitué de la modification stable à haute température HT et la proportion c d'europium dans le cation M étant comprise entre 0,1 et 20 % en moles de M, la proportion d'impuretés sur le tungstène et le cobalt étant à chaque fois inférieure à 100 ppm par rapport aux précurseurs,
la proportion de phases étrangères dans le spectre XRD de la substance luminescente étant choisie de telle sorte qu'à l'angle de déflexion XRD 2θ dans la plage de 25 à 32°, l'intensité de tous les pics de phases étrangères est inférieure à 1/3 de l'intensité du pic principal caractérisant la modification HT à environ 31,8°.

2. Substance luminescente selon la revendication 1, **caractérisée en ce que** le strontium en tant que M représente la partie prédominante et qu'une partie de M, en particulier jusqu'à 30 % en moles, est remplacée par du baryum et/ou du calcium.

3. Substance luminescente selon la revendication 1, **caractérisée en ce que** le strontium en tant que M représente la partie prédominante et qu'une partie de M, en particulier jusqu'à 30 % en moles, est remplacée par du lithium et/ou du lanthane et/ou du zinc.

4. Substance luminescente selon la revendication 1, **caractérisée en ce qu'**une partie du groupe SiN dans l'oxynitridosilicate de formule MSi₂O₂N₂, en particulier jusqu'à 30 % en moles, est remplacée par le groupe AlO.

5. Substance luminescente selon la revendication 1, **caractérisée en ce qu'**une partie de l'europium, en particulier jusqu'à 30 % en moles, est remplacée par du manganèse.

6. Substance luminescente selon la revendication 1, **caractérisée en ce que** la proportion d'impuretés sur le tungstène et le cobalt est inférieure à 50 ppm par rapport aux précurseurs.

7. Substance luminescente selon la revendication 1, **caractérisée en ce que** l'oxynitridosilicate est constitué de la modification HT à plus de 70 %, en particulier à plus de 85 %.

8. Substance luminescente selon la revendication 1, **caractérisée en ce que** l'oxynitridosilicate est principalement constitué de la modification HT et que la proportion de phases étrangères est inférieure à 15 %.

9. Substance luminescente selon la revendication 1, **caractérisée en ce que** la largeur à mi-hauteur (FWHM) de l'émission de la substance luminescente sous excitation photonique provenant d'une région avec un pic d'émission compris entre 50 et 480 nm est inférieure à 90 nm.

10. Substance luminescente selon la revendication 1, **caractérisée en ce que** dans son spectre XRD, la proportion de la phase NT est choisie de telle sorte que le pic caractéristique de la modification NT dans le spectre XRD à environ 28,2° présente une intensité inférieure à 1:1, de préférence inférieure à 1:2, par rapport au pic ayant la plus forte intensité du groupe triple des réflexes de la modification HT qui, dans le spectre XRD, se situent entre 25 et 27°.

11. Source lumineuse avec une source de rayonnement primaire émettant un rayonnement à ondes courtes du domaine spectral optique, compris dans une plage de longueurs d'onde comprise entre 50 et 480 nm, ce rayonnement étant converti entièrement ou partiellement en un rayonnement secondaire de plus grande longueur d'onde, en particulier dans le domaine spectral visible, au moyen d'au moins une première substance luminescente selon l'une des revendications précédentes.

12. Source lumineuse selon la revendication 11, **caractérisée en ce qu'**une diode électroluminescente à base d'InGaN est utilisée comme source de rayonnement primaire.

13. Source lumineuse selon la revendication 12, **caractérisée en ce qu'**une partie du rayonnement primaire est en outre convertie en un rayonnement de plus grande longueur d'onde au moyen d'une deuxième substance luminescente supplémentaire, les deux substances luminescentes en particulier, à savoir la première et la deuxième, étant choisies et mélangées de manière appropriée afin de produire de la lumière blanche.

14. Source lumineuse selon la revendication 11, **caractérisée en ce qu'**une partie du rayonnement primaire est en outre convertie en un rayonnement de plus grande longueur d'onde au moyen d'une troisième substance luminescente, ladite troisième substance luminescente émettant dans le domaine spectral rouge, en particulier avec un pic dans la plage comprise entre 580 et 670 nm.

15. Procédé de fabrication d'une substance luminescente à haut rendement selon la revendication 1, **caractérisé par** les étapes suivantes :
a) mise à disposition des produits de départ SiO₂, Si₃ N₄, le reste du MCO₃ ainsi que d'un précurseur de l'europium dans des proportions majoritairement stœchiométriques et mélange des produits, les matières premières présentant un taux de pureté élevé par rapport aux impuretés sur le tungstène et le cobalt, inférieur à 100 ppm.
b) Recuit du mélange à environ 1300 à 1600 °C, de préférence 1450 à 1580 °C.

16. Procédé selon la revendication 15, **caractérisé en ce que** les produits de départ présentent une réactivité élevée d'au moins 6 m²/g de surface BET.

17. Procédé selon la revendication 15, **caractérisé en ce que** le dépôt stœchiométrique de tous les composants est maintenu avec précision à au moins 10 %.
